Europäisches Patentamt

European Patent Office

Office européen des brevets

(19)

(11) **EP 0 613 244 B1**

(12) **FASCICULE DE BREVET EUROPEEN**

(45) Date de publication et mention
de la délivrance du brevet:
**18.11.1998 Bulletin 1998/47**

(51) Int Cl.⁶: **H03G 11/00, H03G 11/04**

(21) Numéro de dépôt: **94400357.3**

(22) Date de dépôt: **18.02.1994**

(54) **Dispositif à grande linéarité de limitation d'une caractéristique d'un signal, et utilisation du dispositif dans une chaîne de réception radar**

Vorrichtung mit grossen Linearität der Begrenzung einer Eigenschaft eines Signals und Verwendung der Vorrichtung in einem Radarempfänger

Circuit with high linearity of limitation of a characteristic of a signal and the use of the circuit in a radar-receiver

(84) Etats contractants désignés:
**DE FR GB IT SE**

(30) Priorité: **23.02.1993 FR 9302055**

(43) Date de publication de la demande:
**31.08.1994 Bulletin 1994/35**

(73) Titulaire: **THOMSON-CSF**
**75008 Paris (FR)**

(72) Inventeurs:
• **Beaucourt, Dominique**
**F-92402 Courbevoie Cedex (FR)**
• **Lemaire, Daniel**
**F-92402 Courbevoie Cedex (FR)**
• **Wechsler, Gilles**
**F-92402 Courbevoie Cedex (FR)**

(74) Mandataire: **Benoit, Monique et al**
**Thomson-CSF Propriété Intellectuelle,**
**13, Avenue du Président Salvador Allende**
**94117 Arcueil Cédex (FR)**

(56) Documents cités:
**US-A- 3 974 400          US-A- 3 988 694**
**US-A- 5 111 202**

## Description

La présente invention concerne un dispositif à grande linéarité de limitation d'une caractéristique d'un signal, et notamment de l'amplitude d'un signal radar dans une chaîne de réception à grande linéarité.

Il est déjà connu d'utiliser un limiteur dans les chaînes de réception classiques des systèmes radar.

Le limiteur a pour but d'effectuer une fonction de limitation du signal reçu avant que ce dernier ne soit codé, ceci afin d'interdire au signal de dépasser le niveau maximal de codage possible, et d'entraîner par conséquent une saturation numérique ou d'endommager le codeur. Cette fonction de limitation doit être assurée avec un minimum de dégradations des performances de dynamique et de linéarité.

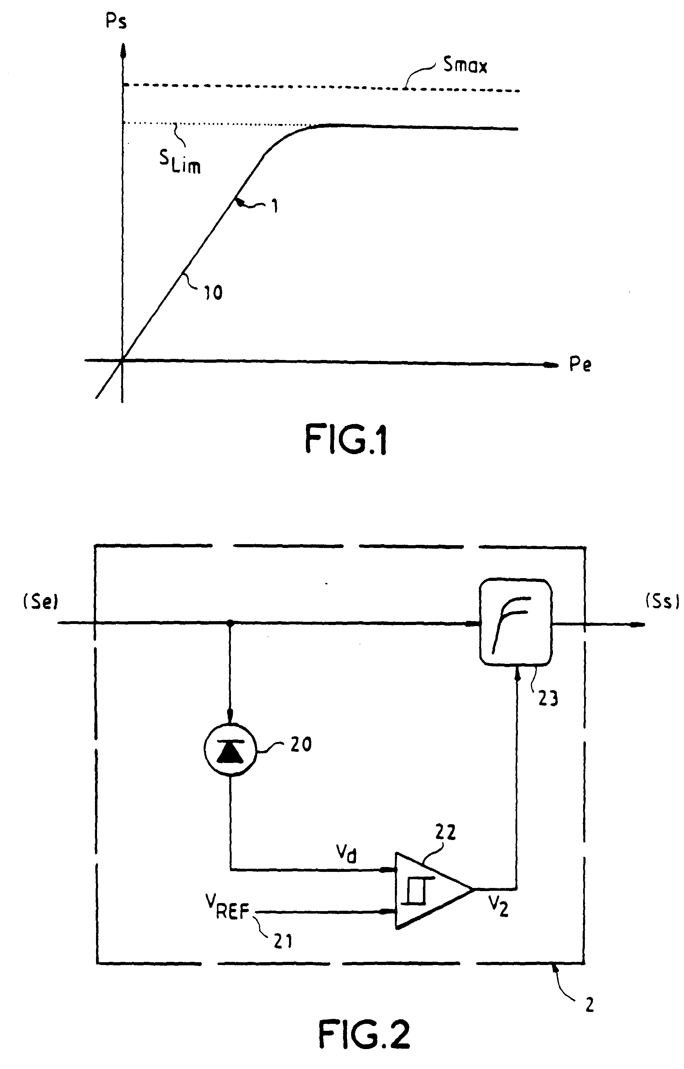

Les limiteurs classiques possèdent une fonction de transfert en puissance dont l'allure est représentée par la courbe 1 de la figure 1. Sur cette figure, la puissance $P_e$ reportée en abscisse, et la puissance $P_s$ reportée en ordonnée représentent respectivement les puissances d'entrée et de sortie d'un limiteur classique de l'art antérieur. On a représenté en traits pointillés le seuil maximum de codage $S_{max}$ d'un codeur supposé être en sortie du limiteur. On définit, pour le limiteur, un seuil limite $S_{lim}$ représentant la puissance de sortie maximum que peut avoir un signal délivré par le limiteur. Ce seuil $S_{lim}$ est inférieur au seuil $S_{max}$, de sorte que l'on ne risque jamais la saturation numérique. En deçà du seuil $S_{lim}$, la puissance de sortie $P_s$ est une fonction linéaire de la puissance d'entrée $P_e$.

Dans une chaîne de réception classique, la dégradation de la linéarité introduite par de tels limiteurs reste acceptable. Par contre, dans une chaîne de réception à grande linéarité, l'utilisation des limiteurs classiques présente l'inconvénient majeur décrit ci-après :

De manière à profiter au maximum de la dynamique du codeur utilisé dans la chaîne de réception, et ceci, sans risquer la saturation, il convient d'amener le signal d'entrée du limiteur, par l'intermédiaire des étages précédents, au plus proche du niveau maximal de codage $S_{max}$. Le signal d'entrée est donc très proche du seuil de limitation $S_{lim}$.

Or, cela se fait au détriment de la performance en linéarité, celle-ci n'étant optimale que lors d'un fonctionnement dit "petit signal", c'est-à-dire pour des signaux d'entrée de niveaux bien inférieurs au seuil de limitation $S_{lim}$.

L'utilisation d'un limiteur classique pour se protéger d'une saturation numérique du codeur se heurte donc à une incompatibilité entre, d'une part, la recherche d'une exploration optimale de la dynamique du codeur, et, d'autre part, la nécessité d'avoir une performance de linéarité optimale.

La présente invention a pour objectif de proposer un dispositif de limitation ne présentant pas l'incompatibilité précédente.

Plus précisément, la présente invention a pour objet un dispositif à grande linéarité de limitation d'une caractéristique d'un signal à une valeur seuil $S_{max}$ prédéterminée, du type comportant un limiteur recevant sur son entrée ledit signal, et possédant un seuil de limitation $S_{lim}$, ledit dispositif étant caractérisé en ce que le seuil de limitation est commutable sur deux valeurs possibles prédéterminées $S_h$ et $S_b$ respectivement supérieure et inférieure à ladite valeur seuil $S_{max}$, et en ce qu'il comporte :

- des moyens de mesure recevant à leur entrée ledit signal et délivrant une mesure représentative de la caractéristique ;
- des moyens de commande de la commutation du seuil de limitation $S_{lim}$ sur la valeur $S_h$ lorsque ladite mesure est inférieure à un seuil de comparaison $V_H$, et sur la valeur $S_b$ lorsque ladite mesure est supérieure audit seuil de comparaison, le seuil de comparaison étant déterminé de façon à ce que la caractéristique du signal ne soit jamais supérieure à la valeur seuil $S_{max}$.

L'invention a également pour objet une utilisation du dispositif selon les revendications 1 à 7 dans une chaîne de réception radar à grande linéarité, caractérisée en ce que ledit dispositif est placé en série entre un récepteur qui lui délivre un signal radar, et un convertisseur analogique-numérique dont le seuil maximum de codage est égal à ladite valeur seuil $S_{max}$.

L'invention, ainsi que ses avantages, seront mieux compris au vu de la description suivante, faite en référence aux figures annexées, et concernant plus particulièrement la limitation de l'amplitude d'un signal radar dans une chaîne de réception à grande linéarité :

- La figure 1 représente l'allure de la fonction de transfert en puissance d'un limiteur classique ;
- La figure 2 est un schéma de principe du fonctionnement du dispositif de limitation selon l'invention ;
- La figure 3 illustre l'allure de la fonction de transfert en puissance du dispositif de limitation selon l'invention ;
- La figure 4 est un chronogramme illustrant l'action du dispositif de limitation suivant l'amplitude du signal d'entrée $S_e$ ;
- La figure 5 est un mode de réalisation possible d'un dispositif de limitation selon l'invention ;
- La figure 6 montre l'utilisation d'un dispositif selon l'invention dans une chaîne de réception radar.

La figure 1 a déjà été décrite précédemment.

La figure 2 illustre le principe de fonctionnement du dispositif de limitation 2 d'un signal selon l'invention. Il se compose essentiellement d'un limiteur 23 dont le seuil de limitation $S_{lim}$ peut être commandé, et d'une branche de contrôle constituée de moyens de mesure 20 d'une caractéristique du signal traité, par exemple l'amplitude, et de moyens de commande 21, 22 commandant automatiquement le seuil de limitation du limiteur suivant la valeur de la tension $V_d$ délivrée par les moyens de mesure 20.

Plus précisément, selon la valeur de cette tension $V_d$, le seuil de limitation $S_{lim}$ du limiteur 23 est commutable sur deux valeurs possibles prédéterminées $S_h$ et $S_b$ respectivement supérieure et inférieure à la valeur seuil $S_{max}$ du codeur.

Tant que le signal $S_e$ en entrée du dispositif 2 a une amplitude inférieure à la valeur seuil $S_{max}$, le limiteur dispose d'un seuil de limitation de valeur $S_h$ élevée. Le limiteur fonctionne alors en "petit signal", ce qui permet d'avoir une performance en linéarité optimale.

Par contre, dès que les moyens de mesure 20 délivrent une tension $V_d$ représentative d'un signal de caractéristique trop élevée proche du seuil $S_{max}$ de codage, les moyens de commande 21, 22 réduisent automatiquement et en temps réel le seuil de limitation du limiteur 23 à la seconde valeur $S_b$. Le codeur est ainsi protégé contre la saturation.

De même, le niveau de limitation est automatiquement relevé à la valeur $S_h$ dès lors que le signal d'entrée redescend suffisamment sous le seuil de codage $S_{max}$.

La commutation du seuil du limiteur présente l'avantage de ne pas perturber le signal comme le ferait une commutation située avant un limiteur classique à un seuil et qui aurait pour rôle d'éviter de faire passer dans le limiteur un signal d'entrée qu'il n'est pas nécessaire de limiter voir par exemple le document US 3,988,694 décrivant une commutation située avant un limiteur. Une telle commutation nécessiterait en outre de prévoir un autre cheminement pour le signal afin qu'il soit délivré au codeur sans passer par le limiteur.

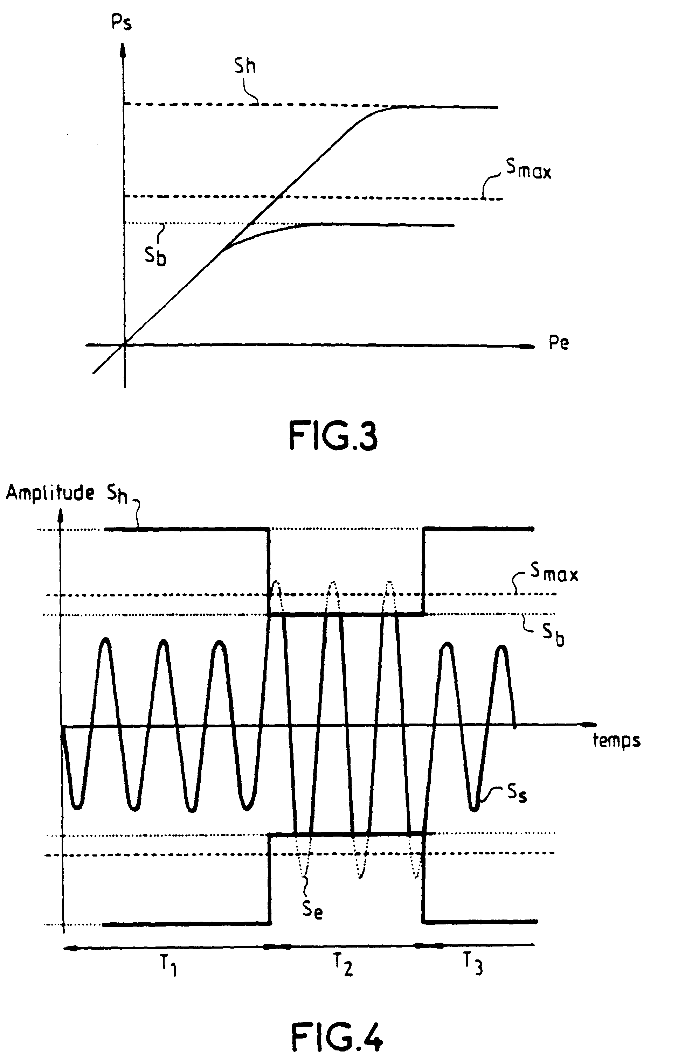

La figure 3 représente la fonction de transfert en puissance du dispositif selon l'invention, suivant la valeur du seuil de limitation $S_{lim}$.

Le seuil haut $S_h$ est choisi suffisamment supérieur au seuil de codage $S_{max}$ de sorte que le dispositif fonctionne en "petit signal" lorsque le signal d'entrée ne risque pas de provoquer de saturation. Par exemple, si l'on désire une linéarité d'environ 60 dB, le seuil haut $S_h$ sera choisi préférentiellement à au moins 10 dB au-dessus de $S_{max}$. La linéarité de la chaîne de réception n'est alors pas dégradée et l'on peut profiter de toute la dynamique de codage.

Le seuil bas $S_b$ est, quant à lui, choisi suffisamment proche du niveau maximum de codage, par exemple à 2 dB en-dessous de $S_{max}$.

Les valeurs précédemment citées dépendent bien évidemment des performances recherchées, ainsi que de la technologie utilisée.

La figure 4 est un chronogramme illustrant l'allure du signal $S_s$ en sortie d'un dispositif de limitation selon l'invention, recevant un signal sinusoïdal $S_e$ d'amplitude variable.

Pendant les intervalles de temps $T_1$ et $T_3$, l'amplitude du signal $S_e$ est inférieure au seuil de codage $S_{max}$. Le limiteur a un seuil de limitation $S_h$ qui ne dégrade pas la linéarité du dispositif. Le signal de sortie $S_s$ est identique au signal d'entrée $S_e$.

Par contre, sur l'intervalle de temps $T_2$, l'amplitude du signal $S_e$ dépasse la valeur $S_{max}$. Le limiteur est alors commuté sur son seuil de limitation $S_b$ de façon à ne pas saturer le codeur.

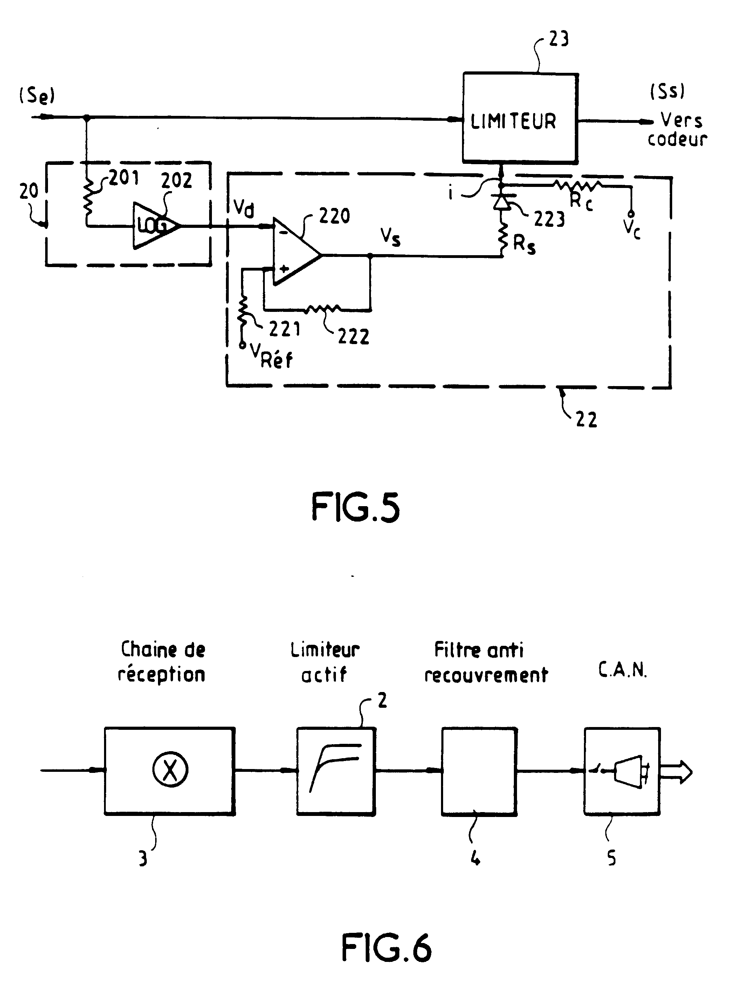

La figure 5 est un exemple non limitatif de réalisation d'un dispositif de limitation selon l'invention. Le signal d'entrée $S_e$ considéré est par exemple un signal radar analogique hyperfréquence.

De manière préférentielle, les moyens de mesure 20 détectent l'amplitude du signal présent à l'entrée du limiteur. La décision de commutation du limiteur sur l'un de ces deux seuils de limitation possibles s'effectue par l'analyse de la valeur $V_d$ de cette amplitude détectée. Avantageusement, les moyens de mesure 20 détectent l'amplitude du signal grâce à un amplificateur logarithmique 202, permettant de prélever le signal en haute impédance 201 sans perturber la ligne hyperfréquence.

La décision de commutation du limiteur sur l'un des deux seuils de limitation $S_h$, $S_b$ possibles s'effectue au niveau des moyens de commande 22, par comparaison de la valeur $V_d$ de l'amplitude détectée par rapport à au moins un seuil de comparaison $V_H$ d'un comparateur 220 délivrant une tension $V_s$ représentative de la comparaison. Ce seuil $V_H$ est réglé par la valeur d'une tension de référence $V_{REF}$ et d'une résistance 221, de telle sorte qu'en présence d'un signal d'entrée ne risquant pas d'entraîner une saturation, le limiteur soit positionné sur son seuil haut $S_h$. Dans l'exemple de réalisation de la figure 5, le limiteur 23 est commandé en courant par la valeur du courant i à son entrée de commande, et indirectement par la valeur de la tension $V_s$ en sortie du comparateur 220. Pour ce faire, les moyens de commande 22 disposent, en plus du comparateur 220, d'une commande en courant réalisée à partir des deux résistances $R_s$ et $R_c$ et d'une alimentation $V_c$.

Tant que la valeur $V_d$ de l'amplitude détectée est inférieure au seuil $V_H$ du comparateur 220, celui-ci délivre une tension continue $V_s$, et le courant i en entrée du limiteur 23 est donné par la relation

$$i = \frac{V_s}{R_s} + \frac{V_c}{R_c}$$

et correspondant au seuil haut $S_h$ du limiteur 23.

Dès que cette valeur $V_d$ devient supérieure au seuil $V_H$ du comparateur, ce dernier délivre une autre valeur de tension inférieure au seuil $V_H$, par exemple nulle, et le courant i s'exprime par la relation:

$$i = \frac{V_c}{R_c}$$

correspondant au seuil bas $S_b$ du limiteur 23.

La résistance $R_c$ et l'alimentation $V_c$ permettent ici de régler la valeur du seuil bas $S_b$, et la résistance $R_s$ celle du seuil haut $S_h$. Une diode 223 évite que le courant passant dans la résistance $R_c$ passe également dans la résistance $R_s$.

Dans l'exemple de réalisation préférentielle illustré à la figure 5, le comparateur 220 est avantageusement un comparateur à hystérésis à deux seuils $V_H$ et $V_L$ de valeurs déterminées de manière connue par les résistances 221, 222 et par la tension de référence $V_{REF}$. Lorsque l'amplitude détectée $V_d$ dépasse le premier seuil $V_H$, le comparateur bascule et commande la commutation du seuil de limitation du limiteur. Le seuil de comparaison du comparateur 220 est alors diminué à la deuxième valeur $V_L$, inférieure à $V_H$, de façon à empêcher toute commutation parasite due, par exemple, à l'ondulation du signal d'entrée. Dès que l'amplitude détectée $V_d$ redevient inférieure à ce deuxième seuil $V_L$, le limiteur 23 est commuté à nouveau sur son seuil haut $S_h$ de limitation. Le limiteur 23 utilisé peut être un limiteur commercialisé, ou bien un mélangeur utilisé comme limiteur, du type mélangeur en anneaux.

La figure 6 illustre un exemple d'utilisation d'un dispositif de limitation selon l'invention tel que décrit précédemment dans la chaîne de réception d'un radar. Le dispositif de limitation 2 est ici placé en série entre un récepteur hyperfréquence classique 3 et un filtre anti-recouvrement 4 suivi du convertisseur analogique-numérique 5. Le filtre anti-recouvrement 4 a pour rôle de supprimer les harmoniques générées par le limiteur lorsque ce dernier fonctionne sur son seuil bas.

Le dispositif à grande linéarité de limitation selon l'invention utilisé dans une chaîne de réception à grande linéarité permet ainsi d'explorer de façon optimale toute la dynamique du codeur en dégradant au minimum les performances en linéarité.

## Revendications

1. Dispositif à grande linéarité (2) pour la limitation d'une caractéristique d'un signal à une valeur seuil $S_{max}$ prédéterminée, du type comportant un limiteur (23) recevant sur son entrée ledit signal, et possédant un seuil de limitation $S_{lim}$, ledit dispositif étant caractérisé en ce que le seuil de limitation est commutable sur deux valeurs possibles prédéterminées $S_h$ et $S_b$ respectivement supérieure et inférieure à ladite valeur seuil $S_{max}$, et en ce qu'il comporte :

   - des moyens (20) de mesure recevant à leur entrée ledit signal et délivrant une mesure représentative de la caractéristique dudit signal;
   - des moyens (21, 22) de commande de la commutation du seuil de limitation $S_{lim}$ sur la valeur $S_h$ lorsque ladite mesure est inférieure à un seuil de comparaison $V_H$, et sur la valeur $S_b$ lorsque ladite mesure est supérieure audit seuil de comparaison, le seuil de comparaison étant déterminé de façon à ce que la caractéristique du signal ne soit jamais supérieure à la valeur seuil $S_{max}$.

2. Dispositif selon la revendication 1, caractérisé en ce que les moyens de mesure (20) effectuent une détection de l'amplitude du signal et fournissent une valeur $V_d$ représentative de l'amplitude détectée.

3. Dispositif selon la revendication 2, caractérisé en ce que les moyens de mesure (20) sont constitués d'une haute impédance (201) prélevant le signal, et d'un amplificateur logarithmique (202) délivrant ladite valeur $V_d$.

4. Dispositif selon l'une quelconque des revendications précédentes, caractérisé en ce que les moyens de commande comportent un comparateur (220) possédant au moins un seuil représentant ledit seuil de comparaison $V_H$ et délivrant une tension $V_s$ de valeur différente suivant le résultat de la comparaison.

5. Dispositif selon la revendication 4, caractérisé en ce que le seuil de comparaison $V_H$ est réglé de telle sorte que le seuil de limitation $S_{lim}$ du limitateur (23) soit commuté sur la valeur $S_h$ tant que la caractéristique du signal est inférieure à la valeur seuil $S_{max}$.

6. Dispositif selon l'une quelconque des revendications 4 ou 5, caractérisé en ce que les moyens de commande comportent en outre une commande en courant réalisée par deux résistances $R_s$ et $R_c$ en série, alimentée à leur extrémité libre respective par la tension $V_s$ et par une alimentation $V_c$, le courant de commande étant prélevé entre les deux résistances.

7. Dispositif selon l'une quelconque des revendications 4 à 6, caractérisé en ce que le comparateur (220) est un comparateur à hystérésis disposant d'un deuxième seuil de comparaison $V_L$ inférieur à $V_H$.

8. Utilisation du dispositif selon les revendications 1 à 7 dans une chaîne de réception radar à grande linéarité, caractérisée en ce que ledit dispositif (2) est placé en série entre un récepteur (3) qui lui délivre un signal radar, et un convertisseur analogique-numérique (5) dont le seuil maximum de codage est égal à ladite valeur seuil $S_{max}$.

## Patentansprüche

1. Hochlineare Vorrichtung (2) zur Begrenzung einer Eigenschaft eines Signals auf einen vorgegebenen Schwellenwert $S_{max}$, des Typs, der einen Begrenzer (23) enthält, der an seinem Eingang das Signal empfängt und eine Begrenzungsschwelle $S_{lim}$ besitzt, wobei die Vorrichtung dadurch gekennzeichnet ist, daß die Begrenzungsschwelle zwischen zwei vorgegebenen möglichen Werten $S_h$ und $S_b$ umschaltbar ist, die höher bzw. niedriger als der Schwellenwert $s_{max}$ sind, und daß sie enthält:

- Meßmittel (20), die an ihrem Eingang das Signal empfangen und einen Meßwert ausgeben, der die Eigenschaft des Signals darstellt;
- Mittel (21, 22) zum Steuern des Umschaltens der Begrenzungsschwelle $S_{lim}$ zum Wert $S_h$, wenn der Meßwert kleiner als eine Vergleichsschwelle $V_H$ ist, und zum Wert $S_b$, wenn der Meßwert größer als die Vergleichsschwelle ist, wobei die Vergleichsschwelle in der Weise bestimmt ist, daß die Eigenschaft des Signals niemals größer als der Schwellenwert $S_{max}$ ist.

2. Vorrichtung nach Anspruch 1, dadurch gekennzeichnet, daß die Meßmittel (20) eine Erfassung der Amplitude des Signals ausführen und einen Wert $V_d$ liefern, der die erfaßte Amplitude darstellt.

3. Vorrichtung nach Anspruch 2, dadurch gekennzeichnet, daß die Meßmittel (20) aus einer das Signal abgreifenden hohen Impedanz (201) und aus einem den Wert $V_d$ ausgebenden logarithmischen Verstärker (202) gebildet sind.

4. Vorrichtung nach irgendeinem der vorangehenden Ansprüche, dadurch gekennzeichnet, daß die Steuermittel einen Komparator (220) enthalten, der wenigstens eine Schwelle besitzt, die die Vergleichsschwelle $V_H$ darstellt, und der eine Spannung $V_s$ ausgibt, deren Wert je nach Vergleichsergebnis unterschiedlich ist.

5. Vorrichtung nach Anspruch 4, dadurch gekennzeichnet, daß die Vergleichsschwelle $V_H$ in der Weise geregelt wird, daß die Begrenzungsschwelle $S_{lim}$ des Begrenzers (23) zum Wert $S_h$ umgeschaltet wird, solange die Eigenschaft des Signals kleiner als der Schwellenwert $s_{max}$ ist.

6. Vorrichtung nach irgendeinem der Ansprüche 4 oder 5, dadurch gekennzeichnet, daß die Steuermittel außerdem eine Stromsteuerung enthalten, die aus zwei in Serie geschalteten Widerständen $R_s$ und $R_c$ hergestellt sind und an ihrem freien Ende mit einer Spannung $V_s$ bzw. mit einer Versorgung $V_c$ gespeist werden, wobei der Steuerstrom zwischen den zwei Widerständen abgegriffen wird.

7. Vorrichtung nach irgendeinem der Ansprüche 4 bis 6, dadurch gekennzeichnet, daß der Komparator (220) ein Komparator mit Hysterese ist, der eine zweite Vergleichsschwelle $V_L$, die niedriger als $V_H$ ist, hat.

8. Verwendung der Vorrichtung nach den Ansprüchen 1 bis 7 in einer hochlinearen Radarempfangskette, dadurch gekennzeichnet, daß die Vorrichtung (2) in Serie zwischen einen Empfänger (3), der an sie ein Radarsignal liefert, und einen Analog/Digital-Umsetzer (5) geschaltet ist, dessen maximale Codierungsschwelle gleich dem Schwellenwert $S_{max}$ ist.

## Claims

1. Device (2) with high linearity for limitation of a characteristic of a signal to a predetermined threshold value $S_{max}$, of the type comprising a limiter (23) receiving the said signal at its input and having a limitation threshold $s_{lim}$, the said device being characterized in that the limitation threshold can be switched over to two possible predetermined values $S_h$ and $S_b$ that are respectively higher than and lower than the said threshold value $s_{max}$, and in that it comprises:

- measuring means (20) receiving the said signal at their input and delivering a measurement that represents the characteristic of the said signal;
- means (21, 22) to control the switching over of the limitation threshold $s_{lim}$ to the value $S_h$ when the said measurement is lower than a comparision threshold $v_H$ and to the value $S_b$ when the said measurement is higher than the said comparison threshold, the comparison threshold being determined in such a way that the characteristic of the signal is never higher than the threshold value $S_{max}$.

2. Device (2) according to Claim 1, characterized in that the measuring means (20) carry out a detection of the amplitude of the signal and give a value $V_d$ that represents the amplitude detected.

3. Device according to Claim 2, characterized in that the measuring means (20) are constituted by a high impedance (201) tapping off the signal and by a logarithmic amplifier (202) delivering the said value $V_d$.

4. Device according to any one of the preceding claims, characterized in that the control means comprise a comparator (220) having at least one threshold representing the said comparison threshold $V_H$ and delivering a voltage $V_s$ with a different value depending on the result of the comparison.

5. Device according to Claim 4, characterized in that the comparison threshold $V_H$ is adjusted in such a way that the limitation threshold $S_{lim}$ of the limiter (23) is switched over to the value $S_h$ so long as the characteristic of the signal is below the threshold value $S_{max}$.

6. Device according to either of Claims 4 or 5, characterized in that the control means furthermore comprise a current-based control formed by two resistors $R_s$ and $R_c$ in series, supplied at their respective free end with the voltage $V_s$ and a supply $V_c$, the control current being tapped off between the two resistors.

7. Device according to any one of Claims 4 to 6, characterized in that the comparator (220) is a hysteresis comparator having a second comparison threshold $V_L$ that is lower than $V_H$.

8. Use of the device according to Claims 1 to 7 in a high-linearity radar receiving system, characterized in that the said device (2) is placed in series between a receiver (3) which delivers a radar signal to it, and an analog-digital converter (5) whose maximum encoding threshold is equal to the said threshold value $S_{max}$.

FIG.1

FIG.2

FIG.3

FIG.4

FIG.5

FIG.6